(19) **Europäisches Patentamt / European Patent Office / Office européen des brevets**

(11) **EP 4 654 196 A1**

(12) **EUROPEAN PATENT APPLICATION**

(43) Date of publication:
26.11.2025 Bulletin 2025/48

(21) Application number: 25171648.6

(22) Date of filing: 22.04.2025

(51) International Patent Classification (IPC):
*G11C 13/00* (2006.01)     *H10B 63/00* (2023.01)
*H10N 70/20* (2023.01)     *H10N 70/00* (2023.01)

(52) Cooperative Patent Classification (CPC):
**G11C 13/004; G11C 13/003; G11C 13/0069;
H10B 63/24; H10N 70/231; H10N 70/826;
H10N 70/8825; H10N 70/884;** G11C 2013/0073;
G11C 2213/15; G11C 2213/73; G11C 2213/77

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: 22.05.2024 KR 20240066739

(71) Applicant: Samsung Electronics Co., Ltd.
Suwon-si, Gyeonggi-do 16677 (KR)

(72) Inventors:
• **YANG, Kiyeon**
  16678 Suwon-si (KR)
• **SUNG, Hajun**
  16678 Suwon-si (KR)
• **KANG, Youngjae**
  16678 Suwon-si (KR)
• **LEE, Changseung**
  16678 Suwon-si (KR)

(74) Representative: **Elkington and Fife LLP
Prospect House
8 Pembroke Road
Sevenoaks, Kent TN13 1XR (GB)**

(54) **SELF-SELECTING MEMORY MATERIAL, MEMORY DEVICE, AND ELECTRONIC DEVICE INCLUDING THE MEMORY DEVICE**

(57) A self-selecting memory (SSM) material, a memory device, and an electronic device including the memory device are provided. The SSM material may have ovonic threshold switching (OTS) characteristics, may be configured to change a threshold voltage according to a polarity and an intensity of an applied voltage, and may include Ge, Sb, and S.

FIG. 10

EP 4 654 196 A1

**Description**

FIELD OF THE INVENTION

The disclosure relates to a self-selecting memory (SSM) material, a memory device, and an electronic device including the memory device.

BACKGROUND OF THE INVENTION

Due to the development of lightweight, thin, and simple electronic products, the demand for highly integrated memory devices is increasing. In a memory device having a cross-point structure, word lines and bit lines vertically cross each other, and memory cells are arranged in regions in which the word lines and the bit lines cross each other. This structure guarantees a small memory cell size in a plan view. In general, memory cells having a cross-point structure include a 2-terminal selector and a memory device that are connected in series to each other to limit and/or prevent the occurrence of a sneak current between adjacent memory cells. Generally, a memory device may include a memory and a selector that selects the memory. However, recently, self-selecting memory (SSM) devices having both the function of the selector and the function of the memory device have been developed. SSM devices may miniaturize memory devices by implementing the memory and the selector in a single device.

SUMMARY OF THE INVENTION

Provided is a self-selecting memory (SSM) material.
Provided is a memory device.
Provided is an electronic device including a memory device.
Additional aspects will be set forth in part in the description which follows and, in part, will be apparent from the description, or may be learned by practice of the presented embodiments of the disclosure.
According to an example embodiment of the disclosure, a self-selecting memory (SSM) material may include Ge, Sb, and S. The SSM material may have ovonic threshold switching (OTS) characteristics, and may be configured to change a threshold voltage according to a polarity and an intensity of an applied voltage.
In some embodiments, a content of Ge may be greater than or equal to 20 at% and less than or equal to 40 at%.
In some embodiments, a content of Sb may be greater than or equal to 10 at % and less than or equal to 40 at %.
In some embodiments, the SSM material may further include at least one of N, In, Ga, Al, or Si.
In some embodiments, a content of the at least one of N, In, Ga, Al, or Si included in the SSM material may be greater than 0 at% and less than or equal to 10 at%.
In some embodiments, a difference between a set threshold voltage and a reset threshold voltage may be 0.5 V or more.
In some embodiments, the SSM material may not include As.
According to an example embodiment of the disclosure, a memory device may include a first electrode, a second electrode spaced apart from the first electrode, and a memory layer between the first electrode and second electrode, the memory layer having OTS characteristics and being configured to change a threshold voltage according to a polarity and an intensity of an applied voltage. The memory layer may include Ge, Sb, and S.
In some embodiments, the memory layer may have a first state having a first threshold voltage and a second state having a second threshold voltage. The second threshold voltage may be higher than the first threshold voltage.
In some embodiments, when the memory layer may be in the first state, the memory layer may be configured to be converted from the first state to the second state by applying a negative bias voltage to the memory layer so that current flows from the first electrode to the second electrode.
In some embodiments, when the memory layer may be in the second state, the memory layer may be configured to be converted from the second state into the first state by applying a positive bias voltage to the memory layer so that current flows from the second electrode to the first electrode. The positive bias voltage may be greater than or equal to the second threshold voltage.
In some embodiments, the memory device may further include a plurality of bit lines extending in a first direction and a plurality of word lines extending in a second direction, the second direction crossing the first direction. Each of the plurality of bit lines may correspond to the first electrode, and each of the plurality of word lines may correspond to the second electrode. The memory layer may be provided at a point where the plurality of bit lines and the plurality of word lines cross each other.
In some embodiments, the memory device may include a plurality of word planes extending in a third direction, the third direction being perpendicular to a plane extending in a first direction and a second direction crossing each other, the plurality of word planes being apart from each other in the third direction; a plurality of vertical bit lines penetrating the plurality of word planes and extending in the third direction; and a memory cell string surrounding the vertical bit line and extending in the third direction. Each of the plurality of vertical bit lines may correspond to the first electrode. Each of the plurality of word planes may correspond to the second electrode. The memory cell string may correspond to the memory layer.

According to an example embodiment of the disclosure, an electronic device may include a memory device, and a memory controller configured to control the memory device. The memory device may include a first electrode, a second electrode spaced apart from the first electrode above, and a memory layer between the first electrode and second electrode. The memory layer have OTS characteristics, and may be configured to change a threshold voltage according to a polarity and an intensity of an applied voltage. The memory layer may include Ge, Sb, and S.

BRIEF DESCRIPTION OF THE DRAWINGS

The above and other aspects, features, and advantages of certain embodiments of the disclosure will be more apparent from the following description taken in conjunction with the accompanying drawings, in which:

FIG. 1 is a cross-sectional view schematically illustrating a structure of a memory device according to an embodiment;
FIG. 2 is a graph illustrating voltage-current characteristics of a memory layer of a memory device according to an embodiment;
FIG. 3A is a graph illustrating bias voltages for a set operation and a read operation of a memory device according to an embodiment;
FIG. 3B is a graph illustrating bias voltages for a reset operation and a read operation of a memory device according to an embodiment;
FIG. 4A is a conceptual diagram illustrating a trap state inside a memory layer in a pristine state of a memory layer of a memory device according to an embodiment;
FIG. 4B schematically illustrates an energy band diagram of a memory layer in a pristine state of a memory layer of a memory device according to an embodiment;
FIG. 5A is a conceptual view illustrating a trap state inside a memory layer after a positive (+) bias voltage for first firing is applied to the memory layer in a pristine state;
FIG. 5B schematically illustrates an energy band diagram of a region of a memory layer near a first electrode after first firing;
FIG. 5C schematically illustrates an energy band diagram of region of a memory layer near a second electrode after first firing;
FIG. 6A is a conceptual diagram illustrating a trap state inside a memory layer after a negative bias voltage is applied to a first fired memory layer;
FIG. 6B schematically illustrates an energy band diagram of a memory layer region near a first electrode after a negative bias voltage is applied;
FIG. 6C schematically illustrates an energy band diagram of a memory layer region near a second electrode after a negative bias voltage is applied;
FIG. 7 schematically illustrates a band diagram of a space charge region formed by a reset operation in a memory device according to an embodiment;
FIG. 8 illustrates an I-V curve showing that a memory window is generated in a memory device according to an embodiment by simulating a result shown in FIG. 7;
FIG. 9 illustrates an analysis result through a $\triangle$Vth prediction model of a memory device according to an embodiment;
FIG. 10 is a graph illustrating an example of an element composition ratio of a material of a memory layer according to an embodiment;
FIG. 11 is a perspective view schematically illustrating a structure of a memory device according to an embodiment;
FIG. 12 is a plan view illustrating an operation in which the memory device shown in FIG. 11 selects a specific memory cell;
FIG. 13 is a perspective view schematically illustrating a structure of a memory device according to another embodiment;
FIG. 14 is a vertical cross-sectional view schematically illustrating a configuration of one memory cell in the memory device shown in FIG. 13;
FIG. 15 is a horizontal cross-sectional view schematically illustrating a configuration of one memory cell in the memory device shown in FIG. 13;
FIG. 16 is a conceptual view schematically illustrating a device architecture applicable to an electronic device according to some embodiments;
FIG. 17 is a block diagram illustrating a memory system according to an embodiment; and
FIG. 18 is a block diagram illustrating a neuromorphic apparatus and an external device connected thereto, according to an embodiment.

DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, "at least one of A, B, and C," and similar language (e.g., "at least one selected from the group consisting of A, B, and C" and "at least one of A, B, or C") may be construed as A only, B only, C only, or any combination of two or more of A, B, and C, such as, for instance, ABC, AB, BC, and AC.

When the terms "about" or "substantially" are used in this specification in connection with a numerical value, it is intended that the associated numerical value includes a manufacturing or operational tolerance (e.g., $\pm 10\%$) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., $\pm 10\%$) around the stated numerical values or shapes. When ranges are specified, the range includes all values therebetween such as increments of 0.1%.

While the term "equal to" is used in the description of example embodiments, it should be understood that some imprecisions may exist. Thus, when one element is referred to as "equal to" another element, it should be understood that an element or a value may be "equal to" another element within a desired manufacturing or operational tolerance range (e.g., $\pm 10\%$).

The notion that elements are "substantially the same" may indicate that the element may be completely the same and may also indicate that the elements may be determined to be the same in consideration of errors or deviations occurring during a process.

Hereinafter, a self-selecting memory material, a memory device, and an electronic device including the memory device according to various embodiments are described in detail with reference to the accompanying drawings. In the drawings, like reference numerals in the drawings denote like elements, and sizes of components in the drawings may be exaggerated for clarity and convenience of explanation. While such terms as "first," "second," etc., may be used to describe various components, such components must not be limited to the above terms. The above terms are used only to distinguish one component from another.

An expression used in the singular encompasses the expression of the plural, unless it has a clearly different meaning in the context. When a portion "includes" an element, another element may be further included, rather than excluding the existence of the other element, unless otherwise described. Sizes or thicknesses of components in the drawings may be arbitrarily exaggerated for convenience of explanation. Further, when a certain material layer is described as being disposed on a substrate or another layer, the material layer may be in contact with the other layer, or there may be a third layer between the material layer and the other layer. In the following embodiments, materials constituting each layer are provided merely as an example, and other materials may also be used.

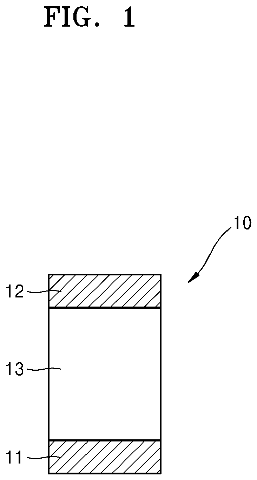

FIG. 1 is a cross-sectional view schematically illustrating a structure of a memory device 10 according to an embodiment.

Referring to FIG. 1, the memory device 10 may include a first electrode 11, a second electrode 12 disposed apart from the first electrode 11, and a memory layer 13 disposed between the first electrode 11 and the second electrode 12.

The first electrode 11 and the second electrode 12 may have a function of applying a voltage to the memory layer 13. To this end, the first electrode 11 and the second electrode 12 may each include a metal, a conductive metal nitride, a conductive metal oxide, or a combination thereof. For example, the first electrode 11 and the second electrode 12 may each include at least of titanium nitride (TiN), titanium Silicon Nitride (TiSiN), titanium carbon nitride (TiCN), titanium Carbon Silicon Nitride (TiCSiN), titanium aluminum nitride (TiAlN), tantalum (Ta), tantalum nitride (TaN), tantalum silicon nitride (TaSiN), tantalum aluminum nitride (TaAlN), tungsten silicide (WSi), titanium tungsten (TiW), molybdenum nitride (MoN), niobium nitride (NbN), titanium boron nitride (TiBN), zirconium silicon nitride (ZrSiN), tungsten silicon nitride (WSiN), tungsten boron nitride (WBN), zirconium aluminum nitride (ZrAlN), molybdenum aluminum nitride (MoAlN), titanium aluminum (TiAl), titanium oxynitride (TiON), Titanium aluminum oxynitride (TiAlON), Tungsten oxynitride (WON), tantalum oxynitride (TaON), silicon carbon (SiC), silicon carbon nitride (SiCN), carbon nitride (CN), tantalum carbonitride (TaCN), tungsten (W), tungsten nitride (WN), and carbon (C), or a combination thereof. In an example, the first electrode 11 and the second electrode 12 may include the same material, but are not limited thereto, and in another example, the first electrode 11 and the second electrode 12 may include different materials.

The memory layer 13 may have ovonic threshold switching (OTS) characteristics in which the memory layer 13 has a high-resistance state when a voltage (e.g., a voltage with a lower absolute value) lower than a threshold voltage is applied to the memory layer 13 and has a low-resistance state when a voltage (e.g., a voltage with a higher absolute value) higher than the threshold voltage is applied to the memory layer 13. The memory layer 13 may perform a selector function by using the OTS characteristics. In addition, the memory layer 13 may have memory characteristics in which the threshold voltage shifts depending on the polarity and intensity of a bias voltage applied to the memory layer 13. The memory layer 13 may perform a memory function by using a change in the threshold voltage. Therefore, the memory device 10 may have characteristics of a self-selecting memory (SSM) capable of performing both the memory function and the selector function with only the single memory layer 13.

As described above, the memory layer 13 may have the OTS characteristics and may include a material whose threshold voltage changes according to the polarity and intensity of the applied voltage. For example, the memory layer 13 may include Ge, Sb, and S. Ge may enhance the thermal stability of the memory device 10, Sb may enhance the stability of an amorphous structure, and S may increase an energy bandgap. The content of Ge included in the memory layer 13 may be about 20 at% or more to about 40 at% or less. Alternatively, the content of Ge included in the memory layer 13 may be about 25 at% or more to about 35 at% or less. The content of Sb included in the memory layer 13 may be about 10 at% or more to about 40 at% or less. Alternatively, the content of Sb included in the memory layer 13 may be about 15 at% or more to about 35 at% or less.

Meanwhile, the memory layer 13 may further include an additional material. The additional material may include at least one of N, In, Ga, Al, or Si. The content of at least one of N, In, Ga, Al, or Si may be about 0 at% or more to about 10 at% or less in the memory layer 13. Alternatively, the content of at least one of N, In, Ga, Al, and Si may be about 2 at% or more to about 8 at% or less in the memory layer 13. Alternatively, the content of at least one of N, In, Ga, Al, or Si may be about 3 at% or more to about 5 at% or less in the memory layer 13. At least one of N, In, Ga, Al, or Si may be included as a dopant in the memory layer 13. N, In, Ga, Al, and Si may be combined with S of the memory layer 13 to enhance the stability of the memory device 10.

For example, when the memory layer 13 includes indium (In), off-current leakage may increase, but resistance and threshold voltage drift characteristics of such indium-based devices may be greatly improved, and threshold voltage shifts may be maintained at similar values.

Meanwhile, the memory layer 13 may be configured not to include arsenic (As). Also, the memory layer 13 may be configured not to include selenium (Se). This will be described in more detail below.

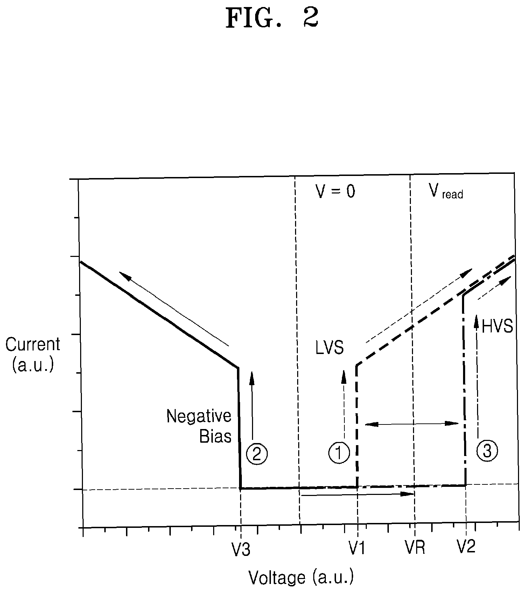

FIG. 2 is a graph illustrating voltage-current characteristics of the memory layer 13 of the memory device 10 according to an embodiment. Referring to FIG. 2, the memory layer 13 may have one of a first state (low Vth state (LVS)) in which a threshold voltage is relatively low and a second state (high Vth state (HVS)) in which the threshold voltage is relatively high. For example, in the first state LVS, the threshold voltage of the memory layer 13 may be a first voltage V1, and in the second state HVS, the threshold voltage of the memory layer 13 may be a second voltage V2 that is greater than the first voltage V1 In the first state LVS, when a voltage less than the first voltage V1 is applied to the self-memory layer 13, substantially no current flows between both ends of the memory layer 13, and when a voltage greater than the first voltage V1 is applied to the memory layer 13, the memory layer 13 turns on and current flows through the memory layer 13. In addition, in the second state HVS, when a voltage less than the second voltage V2 is applied to the memory layer 13, substantially no current flows between both ends of the memory layer 13, and when a voltage greater than the second voltage V2 is applied to the memory layer 13, the memory layer 13 turns on and current flows through the memory layer 13.

Therefore, a voltage between the first voltage V1 and the second voltage V2 may be selected as a read voltage VR. In the first state LVS, when the read voltage VR is applied to the memory layer 13, current flows through the memory layer 13. At this time, a data value stored in the memory layer 13 may be defined as a first binary value or a first logical value "1." In the second state HVS, when the read voltage VR is applied to the memory layer 13, substantially no current flows through the memory layer 13. At this time, a data value stored in the memory layer 13 may be defined as a second binary value or a second logical value "0." In other words, the data value stored in the memory layer 13 may be read by measuring the current flowing through the memory layer 13 while applying the read voltage VR to the memory layer 13.

Meanwhile, in the first state LVS, when a negative bias voltage is applied to the memory layer 13, the threshold voltage of the memory layer 13 may increase and the memory layer 13 may transition to the second state HVS. For example, when a negative third voltage V3 is applied to the memory layer 13, the memory layer 13 may transition to the second state HVS. This operation may be referred to as a 'reset' operation or an erase operation. In addition, in the second state HVS, when a positive bias voltage greater than the second voltage V2 is applied to the memory layer 13, the threshold voltage of the memory layer 13 may decrease and the memory layer 13 may transition to the first state LVS. This operation may be referred to as a 'set' operation or a program operation. A difference between the second voltage V2, which is a reset threshold voltage, and the first voltage V1, which is a set threshold voltage, corresponds to a memory window.

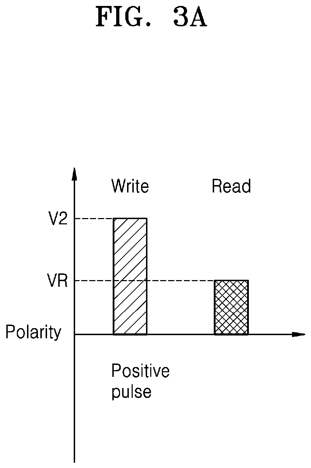

FIG. 3A is a graph illustrating bias voltages for a set operation and a read operation of the memory device 10 according to an embodiment. Referring to FIG. 3A, in the set operation, a positive (+) bias voltage greater than or equal to the second voltage V2 may be applied to the memory layer 13. Then, the threshold voltage of the memory layer 13 may be shifted to the first voltage V1. Thereafter, in the read operation, a positive (+) read voltage VR between the first voltage V1 and the second voltage V2 may be applied to the memory layer 13. When the positive (+) read voltage VR is applied to the memory layer 13, the memory layer 13 may be turned on.

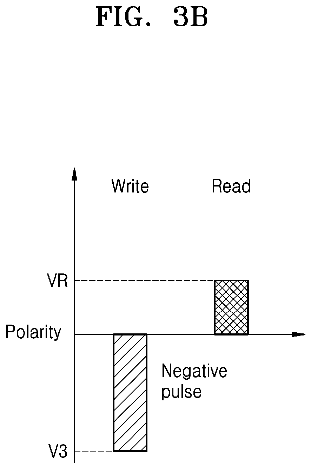

FIG. 3B is a graph illustrating bias voltages for a reset operation and a read operation of the memory device 10 according to an embodiment. Referring to FIG. 3B, in the reset operation, a negative (-) bias voltage, that is, a third voltage V3, may be applied to the memory layer 13. The absolute value of the third voltage V3 may be approximately equal to or slightly greater or less than the second voltage V2. Then, a threshold voltage of the memory layer 13 may be shifted to the second voltage V2 that is greater than the first voltage V1. Thereafter, in the read operation, a positive (+) read voltage VR between the first voltage V1 and the second voltage V2 may be applied to the memory layer 13. When the read voltage VR is applied to the memory layer 13, the memory layer 13 may be turned off.

As described above, the memory layer 13 of the memory device 10 according to an embodiment may have OTS characteristics and may also have memory characteristics in which the threshold voltage of the memory layer 13 varies. For example, the threshold voltage of the memory layer 13 may be shifted according to the polarity of a bias voltage applied to the memory layer 13. In this regard, the memory device 10 according to the embodiment may be a SSM device having polarity dependent threshold voltage shift characteristics.

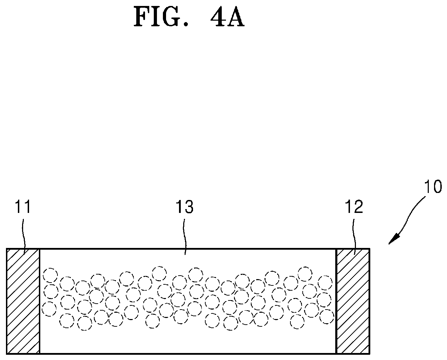

Such a polarity dependent threshold voltage shift behavior may be explained through a change in a trap state inside the memory layer 13. FIGS. 4A to 6B are for conceptually describing a change in a trap state inside the memory layer 13.

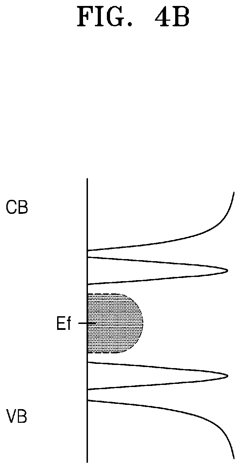

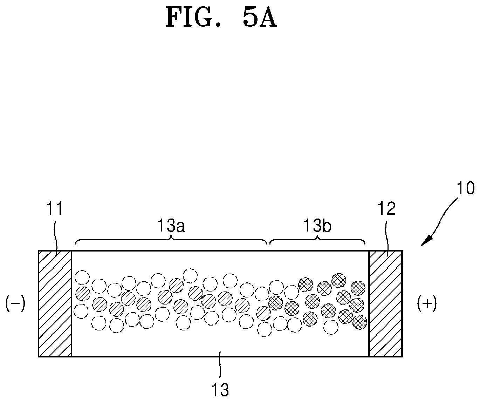

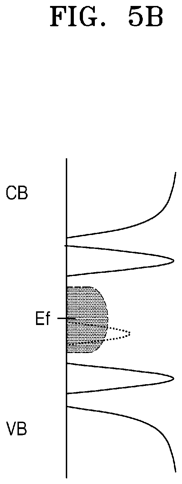

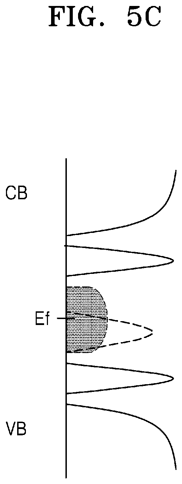

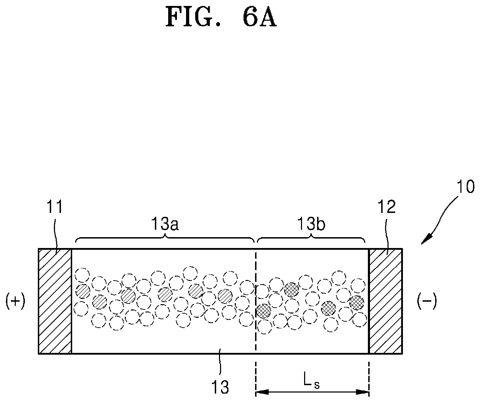

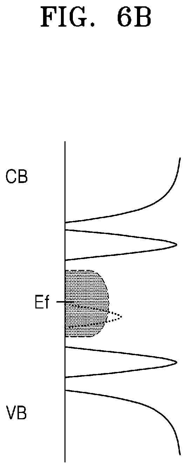

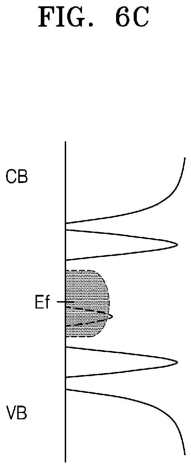

FIG. 4A is a conceptual diagram illustrating a trap state inside a memory layer in a pristine state of the memory layer 13 of the memory device 10 according to an embodiment. FIG. 4B schematically illustrates an energy band diagram of the memory layer 13 in the pristine state. FIG. 5A is a conceptual view illustrating a trap state inside the memory layer 13 after a positive (+) bias voltage for first firing is applied to the memory layer 13 in the pristine state. FIG. 5B schematically illustrates an energy band diagram of a region of the memory layer 13 near the first electrode 11 after first firing. FIG. 5C schematically illustrates an energy band diagram of a region of the memory layer 13 near the second electrode 12 after first firing. FIG. 6A is a conceptual diagram illustrating a trap state inside the memory layer 13 after a negative bias voltage is applied to the first fired memory layer 13. FIG. 6B schematically illustrates an energy band diagram of a region of the memory layer 13 near the first electrode 11 after a negative bias voltage is applied. FIG. 6C schematically illustrates an energy band diagram of a region of the memory layer 13 near the second electrode 12 after a negative bias voltage is applied.

Referring to FIG. 4A, de-activated traps are mainly present in the memory layer 13 immediately after the memory layer 13 is manufactured in the pristine state. For convenience of description, the de-activated traps are indicated by dotted circles in FIG. 4A. The de-activated traps may be mainly formed by covalent bonds between atoms adjacent to each other in the memory layer 13.

In addition, in the graph of FIG. 4B, 'CB' denotes a conduction band, 'VB' denotes a valence band, and a horizontal axis represents a density of state. Referring to FIG. 4B, an energy band formed by de-activated traps is indicated by a thin dashed line. An energy band indicated by a solid line in FIG. 4B is formed of materials other than traps in the memory layer 13. The energy band formed by the de-activated traps may be distributed with respect to the Fermi level Ef.

A positive (+) bias voltage may be applied to first fire the memory layer 13 in the pristine state. For example, a bias voltage may be applied to the memory layer 13 so that current flows from the second electrode 12 to the first electrode 11. Referring to FIG. 5A, some of the de-activated traps may be activated by first firing to form activated traps. The activated traps may be mainly formed by sulfur ions generated when covalent bonds between sulfur (S) atoms are broken. A percolation path or a conduction path may be formed in the memory layer 13 by such activated traps, and a threshold voltage of the memory layer 13 may be decreased by forming the percolation path. Conversely, when the density of state of the activated trap is low, the percolation path may be reduced, and thus the threshold voltage of the memory layer 13 may be increased.

In FIG. 5A, activated traps are represented by a circle of a comb pattern and a circle of a network pattern. As shown in FIG. 5A, the amount of activated traps in the memory layer 13 may increase from the first electrode 11 to the second electrode 12. In particular, a large amount of activated traps may be generated in a region of the memory layer 13 close to the second electrode 12. Therefore, after first firing, the memory layer 13 may include a first region 13a having a relatively low density of activated trap and a second region 13b having a relatively high density of activated trap. A thickness of the second region 13b may be less than a thickness of the first region 13a. For example, the total thickness of the memory layer 13 may be about 10 nm or more to about 30 nm or less, and the thickness of the second region 13b may be about 1 nm or more to about 4 nm or less. However, the disclosure is not limited thereto.

The first region 13a is adjacent to the first electrode 11. The activated traps in the first region 13a are indicated by the circle of the comb pattern. The density of activated trap in the first region 13a may gradually increase toward a boundary with the second region 13b, but the amount of increase may be relatively small. The second region 13b is adjacent to the second electrode 12. In addition, the second region 13b may be in direct contact with the first region 13a and may be disposed between the first region 13a and the second electrode 12. The activated traps in the second region 13b are indicated by the circle of the network pattern. The density of the activated trap in the second region 13b may increase relatively significantly toward the boundary with the second electrode 12. Accordingly, the density of activated trap in the second region 13b may be higher than the density of activated trap in the first region 13a. In this case, the memory layer 13 is in a first state in which the threshold voltage is relatively low. In other words, when the memory layer 13 is in the first state, the density of activated trap in the second region 13b is higher than the density of activated trap in the first region 13a.

Referring to FIG. 5B, the energy band formed by activated traps in the first region 13a is indicated by a dotted line. The energy band formed by the activated traps may be located at an energy level slightly lower than the Fermi level Ef. In addition, referring to FIG. 5C, the energy band formed by activated traps in the second region 13b is indicated by a thick dashed line. When comparing FIG. 5B with FIG. 5C, the energy band formed by the activated traps in the second region 13b has a slightly wider energy distribution than the energy band formed by the activated traps in the first region 13a. In addition, the density of state of activated traps in the second region 13b is greater than the density of state of activated traps in the first region 13a. Therefore, the amount of activated traps in the second region 13b is greater than the amount of activated traps in the first region 13a.

Such a high density of activated trap near the second electrode 12 after first firing may greatly affect a threshold voltage shift behavior of the memory layer 13. For example, the density of activated trap in the second region 13b may be changed relatively easily according to the polarity of a bias voltage, and accordingly, the threshold voltage of the memory layer 13 may be shifted relatively easily, which may enable a relatively easy set operation and/or a relatively easy reset operation.

When a negative (-) bias voltage is applied to the first fired memory layer 13, in other words, when the bias voltage is applied to the memory layer 13 in a reverse direction so that current flows from the first electrode 11 to the second electrode 12, some of the activated traps are annealed in the second region 13b close to the second electrode 12 and are changed to de-activated traps. This may be explained by recombining neighboring sulfur ions and forming covalent bonds. As a result, the density of activated traps in the memory layer 13 is reduced.

When comparing FIG. 5A with FIG. 6A, after the negative (-) bias voltage is applied to the memory layer 13, the density of activated traps in both the first region 13a and the second region 13b may be reduced. The density of the activated traps in the second region 13b may be significantly reduced compared to the first region 13a. On the other hand, a density change amount of the activated traps in the first region 13a may be less than a density change amount of the activated traps in the second region 13b. Accordingly, after the negative (-) bias voltage is applied to the memory layer 13, the density of the activated traps in the second region 13b may be less than the density of the activated traps in the first region 13a. As a result, an interface tunneling barrier (ITB) or a space charge region may be formed in the second region 13b. A distance of the second region 13b may be a length Ls of the space charge region.

In addition, when comparing FIG. 5B with FIG. 6B, after the negative (-) bias voltage is applied to the memory layer 13, the density of state of activated traps in the first region 13a may be slightly reduced. On the other hand, when comparing FIG. 5C with FIG. 6C, after the negative (-) bias voltage is applied to the memory layer 13, the density of state of the activated traps in the second region 13b may be relatively significantly reduced. In addition, when comparing FIG. 6B with FIG. 6C, it may be seen that after the negative (-) bias voltage is applied to the memory layer 13, a peak of the density of state of activated traps in the second region 13b is less than a peak of the density of state of activated traps in the first region 13a.

When the amount of activated traps is reduced in the memory layer 13, especially in the second region 13b close to the second electrode 12, the percolation path is reduced. Accordingly, a greater bias voltage is required to form the electrical conduction path, and accordingly, the threshold voltage of the memory layer 13 may increase. At this time, the memory layer 13 is in a second state in which the threshold voltage is relatively high. In other words, when the memory layer 13 is in the second state, the density of the activated trap in the second region 13b may be lower than the density of the activated trap in the first region 13a. In addition, the density of the activated trap in the first region 13a and the density of the activated trap in the second region 13b when the memory layer 13 is in the second state may be lower than the density of the activated trap in the first region 13a and the density of the activated trap in the second region 13b when the memory layer 13 is in first second state, respectively.

Thereafter, when a positive (+) bias voltage greater than or equal to the threshold voltage is applied to the memory layer 13, the threshold voltage of the memory layer 13 may be decreased again as the amount of activated traps in the memory layer 13 increases, especially in the second region 13b. Then, the memory layer 13 may be in the first state again. As described above, in the memory device 10 according to the embodiment, the threshold voltage shift behavior may be implemented through a state change of the activated trap in the memory layer 13, especially through a large state change of the activated trap in the second region 13b of the memory layer 13 close to the second electrode 12. Meanwhile, because the density of the activated trap in the pristine state is lower than the density of the activated trap with the negative (-) bias voltage applied after first firing, the positive (+) bias voltage required for first firing may be higher than the positive (+) bias voltage required for decreasing the threshold voltage of the memory layer 13 again after the negative (-) bias voltage is applied.

In the memory device 10 according to the embodiment, the memory layer 13 may include a chalcogenide-based material, for example, an S-based ternary semiconductor compound. The memory layer 13 may include an amorphous semiconductor material. For example, the memory layer 13 may include Ge, Sb, and S. The content of Ge may be about 20 at% or more to about 40 at% or less. The content of Sb may be about 10 at % or more to about 40 at % or less.

In the memory device 10 according to the embodiment, as described below, the memory layer 13 may include a semiconductor compound in which the length Ls of the space charge region is approximately 1 nm or more, thereby increasing a memory window of the memory device 10. Also, the memory layer 13 may be configured not to include arsenic (As) and selenium (Se). As described above, the memory layer 13 include the semiconductor compound excluding arsenic (As) and selenium (Se), thereby reducing environmental pollution. In addition, arsenic (As) is difficult in an atomic layer deposition process, whereas sulfur (S) is capable of the atomic layer deposition process, and thus, the memory device 10 according to the embodiment may be deposited in a three-dimensional (3D) structure, and accordingly, increasing the memory capacity while being small. As such, the material of the memory layer 13 according to the embodiment provides a non-As-based SSM material or a non-Se-based SSM material.

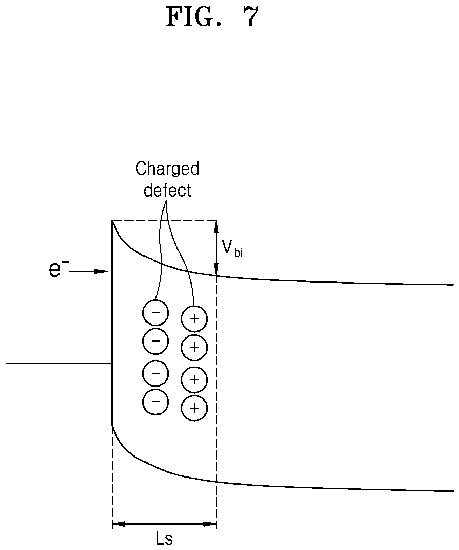

FIG. 7 schematically illustrates a band diagram of a space charge region formed by a reset operation in the memory device 10 according to an embodiment. Referring to FIG. 7, charged defects having different polarities are accumulated near an interface of the memory layer 13 during the reset operation, and the space charge region is formed due to band bending. The space charge region serves as an electrical barrier to prevent electron injection during a read operation. In FIG. 7, "Ls" refers to the length of the space charge region, and "Vbi" refers to a built-in potential or a potential barrier.

Ls may be calculated by the following equation.

$$L_S = \sqrt{\frac{2\varepsilon_0\varepsilon_r}{qN_t}(Vbi - V)}$$   <Equation 1>

Here, $\varepsilon_0$ represents a dielectric constant of vacuum, $\varepsilon_r$ represents a dielectric permittivity, Nt represents a trap density, Vbi represents the built-in potential, q represents an amount of charges, and V represents an applied voltage. When the length Ls of the space charge region is, for example, 1 nm or more, a shift characteristic of a threshold voltage for a SSM device may be secured. However, the length Ls of the space charge region is not limited thereto.

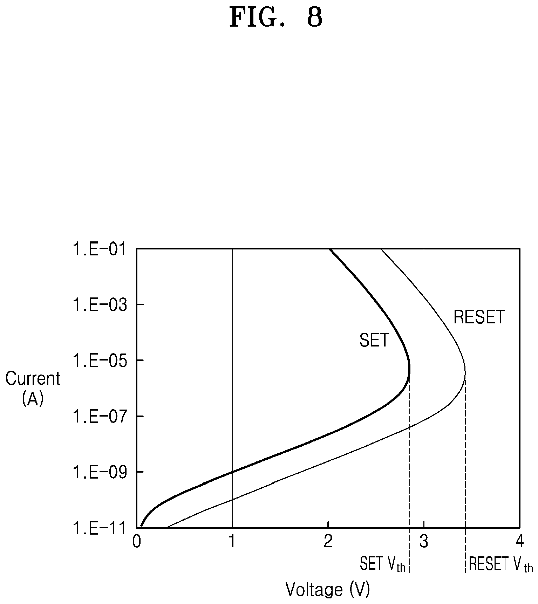

FIG. 8 illustrates an I-V curve showing that a memory window is generated in the memory device 10 according to an embodiment by simulating a result shown in FIG. 7. Referring to FIG. 8, it may be seen that the memory window is generated because a threshold voltage RESET $V_{th}$ in a reset operation is higher than the threshold voltage SET $V_{th}$ in a set operation.

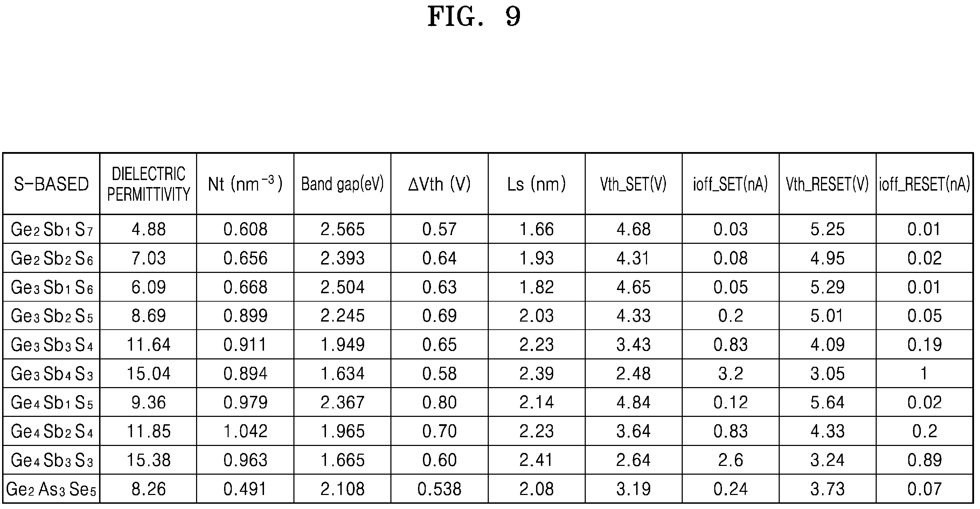

FIG. 9 illustrates results of analysis through a △Vth prediction model while changing the contents of Ge, Sb, and S included in the memory layer 13. In FIG. 9, Nt represents the trap density, Ls represents the length of the spatial charge region, $V_{th}$_SET represents a set threshold voltage, $V_{th}$_RESET represents a reset threshold voltage, ioff_SET represents off-current in a set operation, and ioff_RESET represents off-current in a reset operation. Nt represents the de-activated trap density in a pristine state. △Vth represents the difference between the set threshold voltage $V_{th}$_SET and the reset threshold voltage $V_{th}$_RESET, indicating a memory window.

The last row of a table shown in FIG. 9 shows △Vth with respect to a $Ge_2As_3Se_5$ material, and an OTS behavior and SSM characteristics have been confirmed with respect to Ge, As, and Se ternary materials. Therefore, with respect to △Vth of the $Ge_2As_3Se_5$ material, it may be seen that the Ge-Sb-S-based materials in the table shown in FIG. 9 have SSM characteristics. Referring to FIG. 9, a SSM material according to an embodiment may have the content of Ge of about 20 at% or more to about 40 at% or less. In addition, the content of Sb may be about 10 at% or more to about 40 at% or less. In this case, the SSM material according to an embodiment may implement a relatively large memory window. For example, △Vth of the SSM material according to an embodiment may be 0.5 or more. For example, △Vth of the SSM material according to an embodiment may be about 0.53 or more to about 1.5 or less. Alternatively, △Vth of the SSM material according to an embodiment may be about 0.55 or more to about 0.7 or less.

Meanwhile, hybridization of the memory material according to an embodiment may be 2.6 or less. Hybridization exhibits covalent bond characteristics. OTS characteristics may depend on the covalent bond characteristics of the memory material.

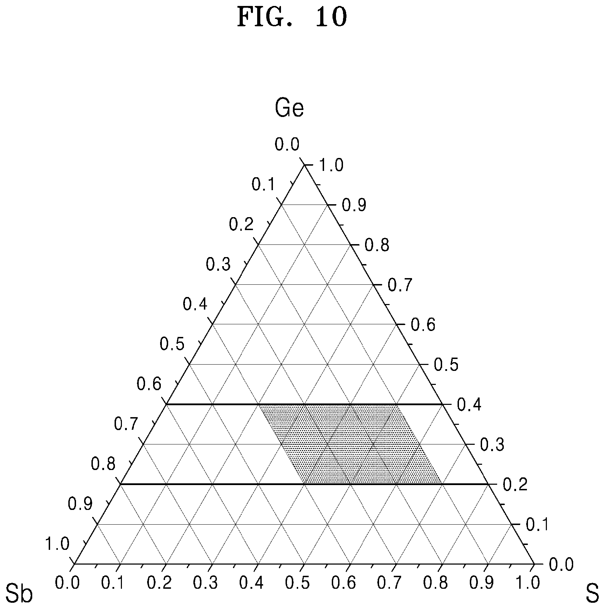

FIG. 10 is a graph illustrating an example of an element composition ratio of a material of the memory layer 13 according to an embodiment. For example, when Ge-Sb-S is used as the material of the memory layer 13, a ratio of germanium (Ge) in the memory layer 13 may be about 20 at% or more to about 40 at% or less, a ratio of antimony (Sb) may be about 10 at% or more to 40 at% or less, and a ratio of sulfur (S) may be about 20 at% or more to about 70 at% or less. FIG. 10 illustrates a composition when Ge-Sb-S is used as the material of the memory layer 13, and when other materials are further used, the composition is not limited thereto and may be slightly changed.

With the composition above, germanium (Ge) may enhance thermal stability, and antimony (Sb) may enhance stability of an amorphous structure. Also, sulfur (S) may increase a band gap. Meanwhile, at least one of N, In, Ga, Al, or Si may be further added to the memory layer 13. These materials may be combined with sulfur (S) to enhance the stability of selector-only memory characteristics.

As described above, the memory device 10 according to an embodiment may perform both a memory function and a selector function with only a single material by using a phenomenon of a change in the density of an activated trap according to the polarity and intensity of a bias voltage. Therefore, a unit memory cell may be implemented with only one memory device 10 without a separate selector. The memory device 10 according to an embodiment may perform both the memory function and the selector function with one memory layer 13, and thus, an aspect ratio of the memory device 10 may be reduced, and the memory device 10 may be manufactured through a relatively simple process.

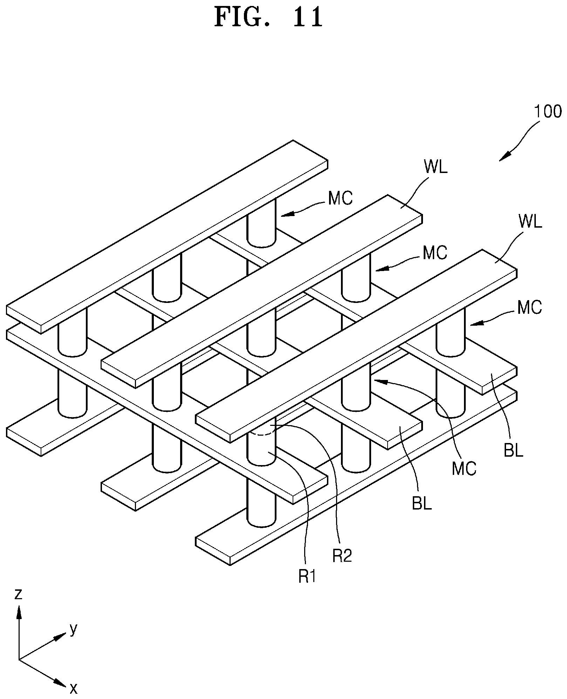

FIG. 11 is a perspective view schematically illustrating a structure of a memory device 100 according to an embodiment. Referring to FIG. 11, the memory device 100 may have a 3D cross-point structure. For example, the memory device 100 may include a plurality of bit lines BL extending in a first direction (that is, an x-axis direction), a plurality of word lines WL extending in a second direction (that is, a y-axis direction) crossing the first direction, and a plurality of memory cells MC provided at points at which the plurality of bit lines BL and the plurality of word lines WL cross each other. Each of the plurality of memory cells MC may have a bar shape and correspond to the memory layer 13 of the memory device 10 shown in FIG. 1. Therefore, each of the plurality of memory cells MC may include the same material as the memory layer 13 of the memory device 10 shown in FIG. 1, and may have the same characteristics. In addition, each of the plurality of bit lines BL may correspond to the first electrode 11 of the memory device 10 shown in FIG. 1, and each of the plurality of word lines WL may correspond to the second electrode 12 of the memory device 10 shown in FIG. 1.

In such a structure, the memory cell MC may be driven by a potential difference between the word line WL and the bit line BL connected to both ends of each of the plurality of memory cells MC. For example, in a first state with a relatively low first threshold voltage, the memory cell MC may change to a second state with a relatively high second threshold voltage when a potential difference between the word line WL and the bit line BL is a (-) bias voltage, e.g., -4 V or more. In addition, in the second state with the relatively high second threshold voltage, the memory cell MC may change to the first state with the relatively low first threshold voltage when the potential difference between the word line WL and the bit line BL is greater than or equal to the second threshold voltage, e.g., +4 V or more. When data recorded in the memory cell MC is read, the potential difference between the word line WL and the bit line BL may be between the first threshold voltage and the second threshold voltage, for example, about +3 V to about +3.5 V. Furthermore, a driving speed of the memory device 100 according to the embodiment may be, for example, about 0.7 nsec or more to about 20 nsec or less, about 0.7 nsec or more to about 10 nsec or less, or about 0.7 nsec or more to about 5 nsec or less.

In addition, as described with reference to FIGS. 5A and 6A, each of the plurality of memory cells MC may have a first region R1 in contact with the corresponding bit line among the plurality of bit lines BL and the second region R2 in contact with a corresponding word line among the plurality of word lines WL. When the memory cell MC is in the first state, the density of activated trap in the second region R2 may be higher than the density of activated trap in the first region R1. On the other hand, when the memory cell MC is in the second state, the density of the activated trap in the second region R2 may be lower than the density of the activated trap in the first region R1.

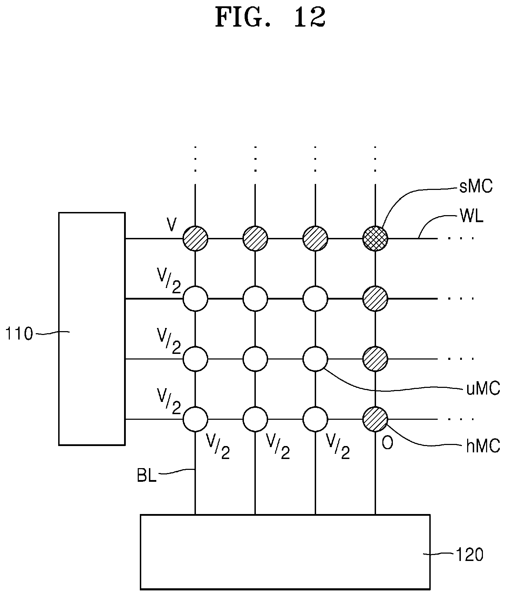

FIG. 12 is a plan view illustrating an operation in which the memory device 100 shown in FIG. 11 selects a specific memory cell. Referring to FIG. 12, the memory device 100 may further include a row decoder 110 configured to selectively supply a voltage to the plurality of word lines WL and a column decoder 120 configured to selectively supply a voltage to the plurality of bit lines BL. When a voltage of V is applied to a selected memory cell sMC from the plurality of memory cells MC, the row decoder 110 may provide the voltage of V to a word line WL connected to the selected memory cell sMC and a voltage of V/2 to the other word lines WL. At this time, the column decoder 120 may provide a voltage of 0 V to a bit line BL connected to the selected memory cell sMC and a voltage of V/2 to the other bit lines BL.

Then, a potential difference between the word line WL and the bit line BL connected to the selected memory cell sMC is V. However, a potential difference between the word lines WL to which the voltage of V/2 is applied and the bit lines BL to which the voltage of V/2 is applied is 0 V. Therefore, no voltage is applied to unselected memory cells uMC disposed between the word lines WL and the bit lines BL that are not connected to the selected memory cell sMC. In addition, the voltage of V/2 may be applied between both ends of each of half-selected memory cells hMC that are connected to the same word line WL as the selected memory cell sMC or the same bit line BL as the selected memory cell sMC. The memory cell MC according to the embodiment is a SSM device having the threshold voltage described above. Even when the voltage of V/2 is applied to the half-selected memory cells hMC adjacent to the selected memory cell sMC, the half-selected memory cells hMC is not turned on, and thus, substantially no sneak current may occur.

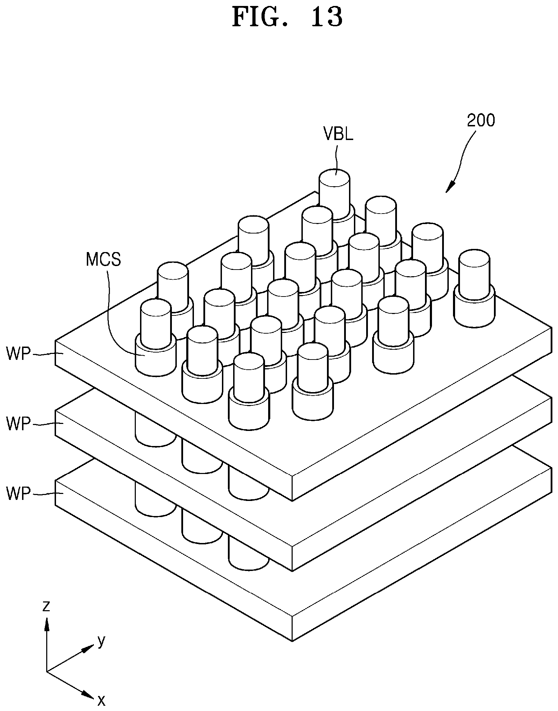

FIG. 13 is a perspective view schematically illustrating a structure of a memory device 200 according to another embodiment. Referring to FIG. 13, the memory device 200 may include a plurality of word planes WP extending along a plane having a first direction (x-axis direction) and a second direction (y-axis direction) and disposed apart from each other in a third direction (z-axis direction) crossing the first direction (x-axis direction) and the second direction (y-axis direction), a plurality of vertical bit lines VBL extending in the third direction (z-axis direction) and two-dimensionally aligned in the first direction (x-axis direction) and the second direction (y-axis direction), and a plurality of memory cell strings MCS surrounding surfaces of the plurality of vertical bit lines VBL and extending in the third direction (z-axis direction). Like the plurality of vertical bit lines VB, the plurality of memory cell strings MCS may be two-dimensionally aligned in the first direction (x-axis direction) and the second direction (y-axis direction). Each of the plurality of memory cell strings MCS and each of the plurality of vertical bit lines VBL may be disposed to penetrate the plurality of word planes WP in the third direction (z-axis direction). Each of the plurality of memory cell strings MCS extends in a vertical direction, that is, in the z-axis direction, and thus, the memory device 200 shown in FIG. 13 may be referred to as a vertical memory device, and may have further enhanced memory capacity. Each of the plurality of memory cell strings MCS may include the same material as the memory layer 13 of the memory device 10 shown in FIG. 1. In addition, each of the plurality of vertical bit lines VBL may correspond to the first electrode 11 of the memory device 10 shown in FIG. 1, and each of the plurality of word planes WL may correspond to the second electrode 12 of the memory device 10 shown in FIG. 1.

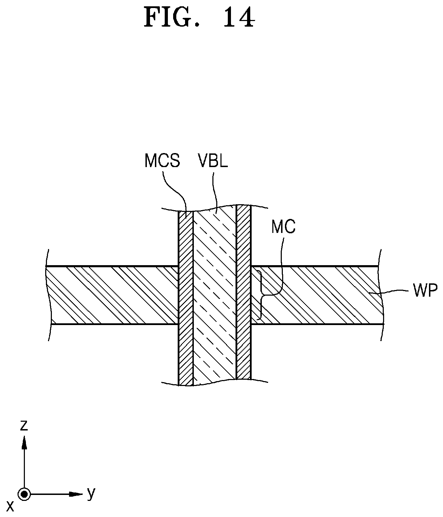

FIG. 14 is a vertical cross-sectional view schematically illustrating a configuration of one memory cell in the memory device 200 shown in FIG. 13. Referring to FIG. 14, a region surrounded by one word plane WP in each of the plurality of memory cell strings MCS extending in the third direction (z-axis direction) may form one memory cell MC. Therefore, one memory cell string MCS may include the plurality of memory cells MC aligned apart from each other in the third direction (z-axis direction). Each of the memory cells MC may correspond to the memory layer 13 of the memory device 10 shown in FIG. 1, and may have the same characteristics as the memory layer 13 of the memory device 10 shown in FIG. 1.

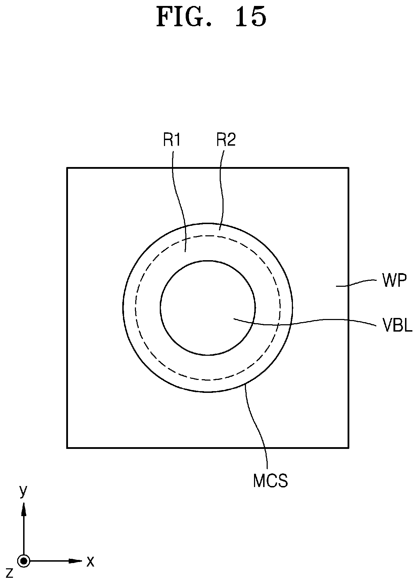

FIG. 15 is a horizontal cross-sectional view schematically illustrating a configuration of one memory cell in the memory device 200 shown in FIG. 13. Referring to FIG. 15, one memory cell MC may have a ring shape. In addition, the memory cell MC may include the first region R1 of a ring shape in contact with and surrounding the corresponding vertical bit line among the plurality of vertical bit lines VBL and the second region R2 of a ring shape surrounding the first region R1. The second region R2 may be in contact with and surrounded by a corresponding word plane among the plurality of word planes WP. The first region R1 and the second region R2 may be aligned concentrically. The first region R1 may correspond to the first region 13a illustrated in FIGS. 5A and 6A, and the second region R2 may correspond to the second region 13b illustrated in FIGS. 5A and 6A. Therefore, when the memory cell MC is in a first state having a relatively low threshold voltage, the density of activated trap in the second region R2 may be higher than the density of activated trap in the first region R1. When the memory cell MC is in a second state having a relatively high threshold voltage, the density of the activated trap in the second region R2 may be lower than the density of the activated trap in the first region R1. Also, a width of the second region R2 in a radial direction may be less than a width of the first region R1 in the radial direction.

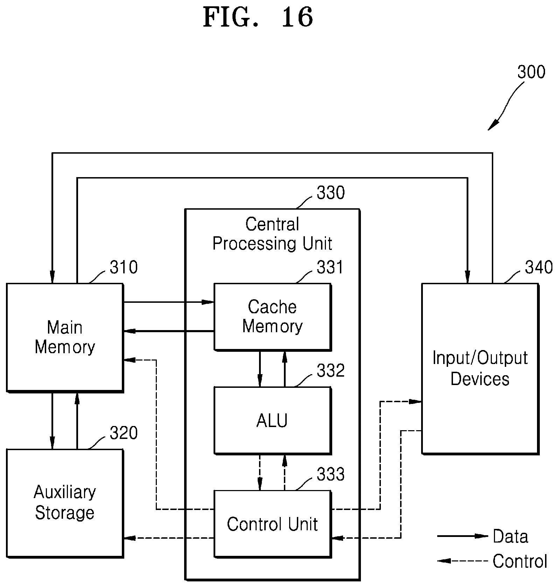

The memory devices 100 and 200 described above may be used for data storage in various electronic devices. FIG. 16 is a conceptual view schematically illustrating a device architecture applicable to an electronic device 300 according to some embodiments. Referring to FIG. 16, the electronic device 300 may include a main memory 310, an auxiliary storage 320, a central processing unit (CPU) 330, and input/output devices 340. The CPU 330 may include a cache memory 331, an arithmetic logic unit (ALU) 332, and a control unit 333. The cache memory 331 may include a static random-access memory (SRAM). The main memory 310 may include a dynamic random-access memory (DRAM) device, and the auxiliary storage 320 may include the memory devices 100 and 200 according to some embodiments. Alternatively, all of the cache memory 331, the main memory 310, and the auxiliary storage 320 may include the memory devices 100 and 200 according to some embodiments. In some cases, the electronic device 300 may be implemented in the form in which computing unit devices and memory unit devices are adjacent to each other on one chip without any distinction between sub-units described above.

Some of elements and/or function blocks disclosed above may be implemented as a processing circuitry such as hardware including a logic circuit, a hardware/software combination such as processor execution software, or a combination thereof. For example, the processing circuitry may include a CPU, an arithmetic logic unit (ALU), a digital signal processor, a microcomputer, a field-programmable gate array (FPGA), a system-on-chip (SoC), a programmable logic unit, a microprocessor, an application-specific integrated circuit (ASIC), etc. The processing circuitry may include electronic components such as at least one of a transistor, a resistor, a capacitor, etc. The processing circuitry may include electronic components such as at least one logic gate such as an AND gate, an OR gate, a NAND gate, a NOT gate, etc.

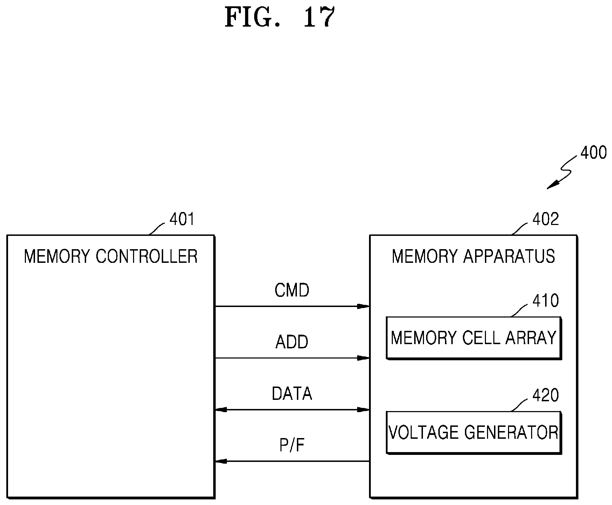

FIG. 17 is a block diagram illustrating a memory system 400 according to an embodiment.

Referring to FIG. 17, the memory system 400 may include a memory controller 401 and a memory apparatus 402. The memory controller 401 may perform a control operation on the memory apparatus 402. For example, the memory controller 401 may provide, to the memory apparatus 402, an address ADD and a command CMD for performing programming (or write), read, and/or erase operations on the memory apparatus 402. In addition, data for the programing operation and the read operation may be transmitted between the memory controller 401 and the memory apparatus 402.

The memory apparatus 402 may include a memory cell array 410 and a voltage generator 420. The memory cell array 410 may include a plurality of memory cells and the memory devices 100 and 200 of the embodiments described above

The memory controller 401 may include a processing circuitry such as hardware including a logic circuit, a hardware/software combination such as processor execution software, or a combination thereof. For example, the processing circuitry may include a CPU, an ALU, a digital signal processor, a microcomputer, a FPGA, a SoC, a programmable logic unit, a microprocessor, an ASIC, etc. but is not limited thereto. The memory controller 401 may operate in response to a request from a host (not shown), and may be configured to converted into a special purpose controller by accessing to the memory apparatus 402 and controlling a control operation (e.g., the write/read operation) discussed above. The memory controller 401 may generate the address ADD and the command CMD for performing the programming/read/erase operation on the memory cell array 410. In addition, in response to a command from the memory controller 401, the voltage generator 420 (e.g. a power circuit) may generate a voltage control signal for controlling a voltage level of a word line to program data in the memory cell array 410 or read data from the memory cell array 410.

In addition, the memory controller 401 may perform a determination operation on data read from the memory apparatus 402. For example, the number of on-cells and/or the number of off-cells may be determined based on the data read from the memory apparatus 402. The memory apparatus 402 may provide pass/fail signals P/F to the memory controller 401 according to a result of reading the data. The memory controller 401 may control the write and read operations of the memory cell array 410 with reference to the pass/fail signals P/F.

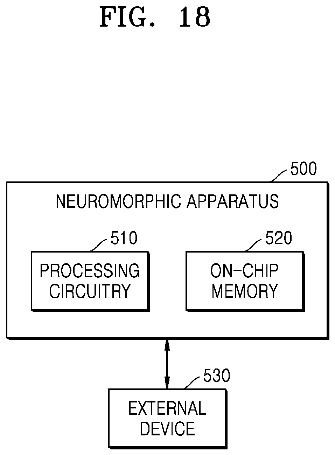

FIG. 18 is a block diagram illustrating a neuromorphic apparatus 500 and an external device 530 connected thereto, according to an embodiment.

Referring to FIG. 18, the neuromorphic apparatus 500 may include a processing circuitry 510 and/or an on-chip memory 520. The on-chip memory 520 may include the memory devices 100 and 200 of the embodiments described above.

In some embodiments, the processing circuitry 510 may be configured to control a function for driving the neuromorphic apparatus 500. For example, the processing circuitry 510 may be configured to control the neuromorphic apparatus 500 by executing a program stored in the on-chip memory 520. In some embodiments, the processing circuitry 510 may include hardware such as a logic circuit, a hardware/software combination such as a processor configured to execute software, or a combination thereof. For example, the processing circuitry 510 may include a CPU, a graphics processing unit (GPU), an application processor (AP) included in the neuromorphic apparatus 500, an ALU, a digital signal processor, a microcomputer, a FPGA, a SoC, a programmable logic unit, a microprocessor, an ASIC, etc. but is not limited thereto. In some embodiments, the processing circuitry 510 may read/write various data with respect to the external device 530, and/or may be configured to execute the neuromorphic apparatus 500 by using the read/written data. In some embodiments, the external device 530 may include an external memory and/or a sensor array having an image sensor (e.g., a complementary metal-oxide-semiconductor (CMOS) image sensor circuit).

In some embodiments, the neuromorphic apparatus 500 may be applied to a machine learning system. The machine learning system may use various artificial neural network organizing and processing models such as a convolutional neural network (CNN), a deconvolutional neural network, a recurrent neural network (RNN) including a long short-term memory (LSTM) unit and/or a gated recurrent unit (GRU), a stacked neural network (SNN), a state-space dynamic neural network (SSDNN), a deep belief network (DBN), a generative adversarial network (GAN), and/or a restricted Boltzmann machine (RBM).

Alternatively or In addition, the machine learning system may include other forms of machine learning models, for example, linear and/or logistic regression, statistical clustering, Bayesian classification, decision tree, dimensionality reduction such as principal component analysis, an expert system, and/or a combination thereof including ensembles such as random forests. These machine learning models may be used to provide various services and/or applications. For example, an image classification service, a user authentication service based on biometrics or biometric data, an advanced driver assistance system (ADAS) service, a voice assistant service, or an automatic speech recognition (ASR) service may be executed by an electronic device.

The memory device according to an embodiment may have a simple structure and simultaneously implement a memory function and a selector function with a single device, and thus, the memory device may be applied to a cross-point memory device, and also to a vertical memory device capable of significantly increasing memory capacity. When applied to the vertical memory device, the structure is simple, and thus, a hole diameter may be reduced, thereby increasing memory density.

The SSM material according to an embodiment includes a chalcogenide-based material, and has OTS characteristics and memory characteristics in which a threshold voltage changes according to the polarity and intensity of an applied voltage. Therefore, a unit memory cell may be implemented with only one memory without a separate selector. The SSM material according to an embodiment includes Ge, Sb, and S, which are capable of atomic layer deposition, and thus, the SSM device may be easily manufactured. In addition, the memory device according to an embodiment may easily implement a 3D stack structure, thereby increasing memory capacity while being small.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

**Claims**

1. A self-selecting memory (SSM) material, comprising:

> Ge;
> Sb; and
> S, wherein
> the SSM material has ovonic threshold switching (OTS) characteristics,
> the SSM material is configured to change a threshold voltage according to a polarity and an intensity of an applied voltage.

2. The SSM material of claim 1, wherein a content of Ge is greater than or equal to 20 at% and less than or equal to 40 at%.

3. The SSM material of claim 1, wherein a content of Sb is greater than or equal to 10 at % and less than or equal to 40 at %.

4. The SSM material of claim 1, further comprising:
   at least one of N, In, Ga, Al, or Si.

5. The SSM material of claim 4, wherein
   a content of the at least one of N, In, Ga, Al, or Si included in the SSM material is greater than 0 at% and less than or equal to 10 at%.

6. The SSM material of claim 1, wherein a difference between a set threshold voltage and a reset threshold voltage is 0.5 V or more.

7. The SSM material of claim 1, wherein the SSM material does not include As.

8. A memory device comprising:

> a first electrode;
> a second electrode spaced apart from the first electrode; and
> a memory layer between the first electrode and second electrode, the memory layer comprising a SSM material according to any preceding claim.

9. The memory device of claim 8, wherein
   the memory layer is configured to have a first state having a first threshold voltage and a second state having a second threshold voltage, and wherein the second threshold voltage is higher than the first threshold voltage.

10. The memory device of claim 9, wherein
    when the memory layer is in the first state, the memory layer is configured to be converted from the first state to the second state by applying a negative bias voltage to the memory layer so that current flows from the first electrode to the second electrode.

11. The memory device of claim 9 or 10, wherein

> when the memory layer is in the second state, the memory layer is configured to be converted from the second state to the first state by applying a positive bias voltage to the memory layer so that current flows from the second electrode to the first electrode, and
> the positive bias voltage is greater than or equal to the second threshold voltage.

12. The memory device of any of claims 8 to 11, further comprising:

> a plurality of bit lines extending in a first direction; and
> a plurality of word lines extending in a second direction, wherein
> the second direction crosses the first direction,
> each of the plurality of bit lines corresponds to the first electrode,

each of the plurality of word lines corresponds to the second electrode, and
the memory layer is provided at a point where the plurality of bit lines and the plurality of word lines cross each other.

13. The memory device of any of claims 8 to 11, further comprising:

a plurality of word planes spaced apart from each other in a third direction, the third direction being perpendicular to a plane extending in a first direction and a second direction crossing each other, the plurality of word planes being apart from each other in the third direction;
a plurality of vertical bit lines penetrating the plurality of word planes and extending in the third direction; and
a memory cell string surrounding the vertical bit line and extending in the third direction, wherein
each of the plurality of vertical bit lines corresponds to the first electrode,
each of the plurality of word planes corresponds to the second electrode, and
the memory cell string corresponds to the memory layer.

14. An electronic device comprising:

a memory device; and
a memory controller configured to control the memory device, wherein
the memory device includes a first electrode, a second electrode spaced apart from the first electrode, and a memory layer between the first electrode and the second electrode,
the memory layer comprising a SSM material according to any of claims 1 to 7.

# FIG. 1

# FIG. 2

# FIG. 3A

FIG. 3B

# FIG. 4A

FIG. 4B

# FIG. 5A

# FIG. 5B

FIG. 5C

# FIG. 6A

FIG. 6B

CB

Ef

VB

FIG. 6C

# FIG. 7

FIG. 8

## FIG. 9

| S-BASED | DIELECTRIC PERMITTIVITY | Nt $(nm^{-3})$ | Band gap(eV) | $\Delta$Vth (V) | Ls (nm) | Vth_SET(V) | ioff_SET(nA) | Vth_RESET(V) | ioff_RESET(nA) |
|---|---|---|---|---|---|---|---|---|---|
| $Ge_2Sb_1S_7$ | 4.88 | 0.608 | 2.565 | 0.57 | 1.66 | 4.68 | 0.03 | 5.25 | 0.01 |
| $Ge_2Sb_2S_6$ | 7.03 | 0.656 | 2.393 | 0.64 | 1.93 | 4.31 | 0.08 | 4.95 | 0.02 |
| $Ge_3Sb_1S_6$ | 6.09 | 0.668 | 2.504 | 0.63 | 1.82 | 4.65 | 0.05 | 5.29 | 0.01 |
| $Ge_3Sb_2S_5$ | 8.69 | 0.899 | 2.245 | 0.69 | 2.03 | 4.33 | 0.2 | 5.01 | 0.05 |
| $Ge_3Sb_3S_4$ | 11.64 | 0.911 | 1.949 | 0.65 | 2.23 | 3.43 | 0.83 | 4.09 | 0.19 |
| $Ge_3Sb_4S_3$ | 15.04 | 0.894 | 1.634 | 0.58 | 2.39 | 2.48 | 3.2 | 3.05 | 1 |
| $Ge_4Sb_1S_5$ | 9.36 | 0.979 | 2.367 | 0.80 | 2.14 | 4.84 | 0.12 | 5.64 | 0.02 |
| $Ge_4Sb_2S_4$ | 11.85 | 1.042 | 1.965 | 0.70 | 2.23 | 3.64 | 0.83 | 4.33 | 0.2 |
| $Ge_4Sb_3S_3$ | 15.38 | 0.963 | 1.665 | 0.60 | 2.41 | 2.64 | 2.6 | 3.24 | 0.89 |
| $Ge_2As_3Se_5$ | 8.26 | 0.491 | 2.108 | 0.538 | 2.08 | 3.19 | 0.24 | 3.73 | 0.07 |

EP 4 654 196 A1

FIG. 10

# FIG. 11

# FIG. 12

# FIG. 13

# FIG. 14

MCS   VBL

MC

WP

z

x → y

# FIG. 15

# FIG. 16

300

330

Central
Processing Unit

310

331

Main
Memory

Cache
Memory

320

332

Auxiliary
Storage

ALU

333

Control Unit

340

Input/Output
Devices

Data

Control

# FIG. 17

400

| 401 | | 402 |
|---|---|---|
| MEMORY CONTROLLER | CMD → ADD → DATA ↔ P/F ← | MEMORY APPARATUS |

MEMORY CELL ARRAY — 410

VOLTAGE GENERATOR — 420

# FIG. 18

NEUROMORPHIC APPARATUS — 500

PROCESSING CIRCUITRY — 510

ON-CHIP MEMORY — 520

EXTERNAL DEVICE — 530

Europäisches
Patentamt
European
Patent Office
Office européen
des brevets

# EUROPEAN SEARCH REPORT

**Application Number**

EP 25 17 1648

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2019/040696 A1 (MICRON TECHNOLOGY INC [US]) 28 February 2019 (2019-02-28) | 1,8-11, 13,14 | INV. G11C13/00 |
| Y | * paragraphs [0046] - [0052], [0081] - [0085], [0105]; figures 1-4,10 * | 2-5,7 | H10B63/00 H10N70/20 H10N70/00 |
| | ----- | | |
| X | CN 116 847 723 A (UNIV HUAZHONG SCIENCE TECH) 3 October 2023 (2023-10-03) | 1,6,8,12 | |
| Y | * paragraphs [0035] - [0038], [0041], [0056] - [0066], [0070]; claims 1,3; figures 1,3 * | 2-5,7 | |
| | ----- | | |
| Y | CLIMA SERGIU ET AL: "In silico screening for As/Se-free ovonic threshold switching materials", MESOSCALE AND NANOSCALE PHYSICS, vol. 9, no. 1, 3 June 2023 (2023-06-03), pages 1-8, XP093311933, ISSN: 2057-3960, DOI: 10.1038/s41524-023-01043-2 * page 1, left-hand column, paragraph 2; figure 1; table 2 * | 2-5,7 | |
| | ----- | | |

**TECHNICAL FIELDS SEARCHED (IPC)**

G11C
H02N
H10B
H10N

The present search report has been drawn up for all claims

| Place of search | Date of completion of the search | Examiner |
|---|---|---|
| The Hague | 10 September 2025 | Colling, Pierre |

EPO FORM 1503 03.82 (P04C01)

## ANNEX TO THE EUROPEAN SEARCH REPORT
## ON EUROPEAN PATENT APPLICATION NO.

EP 25 17 1648

This annex lists the patent family members relating to the patent documents cited in the above-mentioned European search report.
The members are as contained in the European Patent Office EDP file on
The European Patent Office is in no way liable for these particulars which are merely given for the purpose of information.

10-09-2025

| Patent document cited in search report | Publication date | Patent family member(s) | Publication date |
|---|---|---|---|
| WO 2019040696 A1 | 28-02-2019 | CN 111095555 A | 01-05-2020 |
| | | EP 3673509 A1 | 01-07-2020 |
| | | JP 7116156 B2 | 09-08-2022 |
| | | JP 2020532121 A | 05-11-2020 |
| | | KR 20200032766 A | 26-03-2020 |
| | | SG 11202001671X A | 30-03-2020 |
| | | US 2019067571 A1 | 28-02-2019 |
| | | US 2020035917 A1 | 30-01-2020 |
| | | US 2020321520 A1 | 08-10-2020 |
| | | WO 2019040696 A1 | 28-02-2019 |
| CN 116847723 A | 03-10-2023 | NONE | |